## Europäisches Patentamt

## European Patent Office

## Office européen des brevets

(19)

(11) **EP 0 829 101 B2**

(12) ## NEUE EUROPÄISCHE PATENTSCHRIFT

(45) Veröffentlichungstag und Bekanntmachung des Hinweises auf die Entscheidung über den Einspruch:
**28.04.2004  Patentblatt 2004/18**

(45) Hinweis auf die Patenterteilung:
**17.02.1999  Patentblatt 1999/07**

(21) Anmeldenummer: **96915957.3**

(22) Anmeldetag: **31.05.1996**

(51) Int Cl.⁷: **H01L 39/16, H02H 9/02**

(86) Internationale Anmeldenummer:
**PCT/DE1996/000962**

(87) Internationale Veröffentlichungsnummer:
**WO 1996/038864 (05.12.1996 Gazette 1996/53)**

(54) **RESISTIVE STROMBEGRENZUNGSEINRICHTUNG UNTER VERWENDUNG VON HOCH-Tc-SUPRALEITERMATERIAL**

**RESISTIVE CURRENT-LIMITING ARRANGEMENT USING HIGH TEMPERATURE SUPERCONDUCTIVE MATERIAL**

**LIMITEUR DE COURANT RESISTIF UTILISANT UN MATERIAU SUPRACONDUCTEUR A HAUTE TEMPERATURE**

(84) Benannte Vertragsstaaten:
**CH DE FR GB IT LI SE**

(30) Priorität: **01.06.1995  DE 19520205**

(43) Veröffentlichungstag der Anmeldung:
**18.03.1998  Patentblatt 1998/12**

(73) Patentinhaber: **SIEMENS AKTIENGESELLSCHAFT
80333 München (DE)**

(72) Erfinder:
- **RIES, Günter
  D-91056 Erlangen (DE)**
- **NEUMÜLLER, Heinz-Werner
  D-91080 Uttenreuth (DE)**
- **SCHMIDT, Wolfgang
  D-91056 Erlangen (DE)**

(56) Entgegenhaltungen:
**EP-A- 0 345 767        EP-A- 0 523 374
EP-A- 0 660 426        US-A- 4 994 435**

- **PATENT ABSTRACTS OF JAPAN Bd. 018, Nr. 326 (E-1565) 21 Juni 1994 & JP,A,06 077 543 (SUMITOMO ELECTRIC IND LTD) 18 März 1994**
- **PATENT ABSTRACTS OF JAPAN Bd. 018, Nr. 280 (E-1555) 27 Mai 1994 & JP,A,06 053 559 (MITSUBISHI ELECTRIC CORP) 25 Februar 1994**
- **T. Hayashi et al.: "A Study of a High-Tc-Superconducting Fault Current Limiter (No. 2): Development of an Element for 100-V Class Power Systems" Proc. 5th Int. Symp. Superconductivity, Kobe 1992 (Springer Verlag, Tokyo, 1993) Seiten 1263-1266**

EP 0 829 101 B2

**Beschreibung**

Die Erfindung bezieht sich auf eine resistive Strombegrenzungseinrichtung mit einem Trägerkörper vorbestimmter Dicke, mit mindestens einer Leiterbahn. Dabei ist die Leiterbahn für einen vorbestimmten Nennstrom ausgelegt, aus einem Hoch-$T_c$-Supraleitermaterial ausgebildet und an ihren Enden mit elektrischen Kontaktflächen zur Stromzuführung versehen. Eine entsprechende Strombegrenzungseinrichtung ist der EP 0 523 374 A1 zu entnehmen.

In elektrischen Wechselstromversorgungsnetzen können Kurzschlüsse und elektrische Überschläge nicht mit Sicherheit vermieden werden. Dabei steigt der Wechselstrom im betroffenen Stromkreis sehr schnell, d.h. in der ersten Halbwelle, auf ein Vielfaches seines Nennwertes an, bis er durch geeignete Sicherungs- oder Schaltmittel unterbrochen wird. Als Folge treten in allen betroffenen Netzkomponenten wie Leitungen und Sammelschienen, Schaltern oder Transformatoren erhebliche thermische sowie mechanische Belastungen durch Stromkräfte auf. Da diese kurzzeitigen Lasten mit dem Quadrat des Stromes zunehmen, kann eine sichere Begrenzung des Kurzschlußstromes auf einen niedrigeren Spitzenwert die Anforderungen an die Belastungsfähigkeit dieser Netzkomponenten erheblich reduzieren. Dadurch lassen sich Kostenvorteile erzielen, etwa beim Aufbau neuer als auch beim Ausbau bestehender Netze, indem steigenden Kurzschlußströmen durch Einbau von Strombegrenzungseinrichtungen ein Austausch von Netzkomponenten gegen höher belastbare Ausführungsformen vermieden werden kann.

Mit supraleitenden Strombegrenzungseinrichtungen vom resistiven Typ kann der Stromanstieg nach einem Kurzschluß auf einen Wert von wenigen Vielfachen des Nennstromes begrenzt werden; andererseits ist eine solche Begrenzungseinrichtung kurze Zeit nach Abschalten wieder betriebsbereit. Sie wirkt also wie eine schnelle, selbstheilende Sicherung. Sie gewährleistet eine hohe Betriebssicherheit, da sie passiv ist, d.h. autonom ohne vorherige Detektion des Kurzschlusses und aktiver Auslösung durch ein Schaltsignal arbeitet.

Resistive, supraleitende Strombegrenzungseinrichtungen der eingangs genannten Art bilden eine seriell in einem Stromkreis einzufügende supraleitende Schaltstrecke. Dabei wird der Übergang einer supraleitenden Leiterbahn vom praktisch widerstandslosen kalten Betriebszustand unterhalb der Sprungtemperatur $T_c$ des Supraleitermaterials zum normalleitenden Zustand über $T_c$ ausgenutzt, wobei der nun vorhandene elektrische Widerstand $R_n$ der Leiterbahn den Strom auf eine akzeptable Höhe $I=U/R_n$ begrenzt. Die Erwärmung über die Sprungtemperatur $T_c$ geschieht durch Joulesche Wärme in dem Supraleiter der Leiterbahn selbst, wenn nach Kurzschluß die Stromdichte j über den kritischen Wert $j_c$ des Supraleitermaterials ansteigt, wobei das Material auch unterhalb der Sprungtemperatur $T_c$ bereits einen endlichen elektrischen Widerstand aufweist. Im begrenzenden Zustand oberhalb der Sprungtemperatur $T_c$ fließt in dem Stromkreis ein Reststrom weiter, bis ein zusätzlicher mechanischer Trennschalter den Stromkreis völlig unterbricht.

Supraleitende Strombegrenzungseinrichtungen mit bekannten metalloxidischen Hoch-$T_c$-Supraleitermaterialien, deren Sprungtemperatur $T_c$ so hoch liegt, daß sie mit flüssigem Stickstoff von 77 K im supraleitenden Betriebszustand zu halten sind, zeigen eine schnelle Zunahme des elektrischen Widerstandes bei Überschreiten der kritischen Stromdichte $j_c$. Die Erwärmung in den normalleitenden Zustand und somit die Strombegrenzung geschieht dabei in verhältnismäßig kurzer Zeit, so daß der Spitzenwert des Kurzschlußstromes auf einen Bruchteil des unbegrenzten Stromes, etwa auf den drei- bis zehnfachen Nennstrom begrenzt werden kann. Der supraleitende Strompfad ist dabei in Kontakt mit einem Kühlmittel, das ihn in verhältnismäßig kurzer Zeit nach einer Überschreitung der kritischen Stromdichte $j_c$ in den supraleitenden Betriebszustand zurückzuführen vermag.

Mit der aus der eingangs genannten EP-A zu entnehmenden Strombegrenzungseinrichtung sind entsprechende Anforderungen weitgehend zu erfüllen. Die bekannte Einrichtung enthält einen mäanderformig gewundenen elektrischen Leiter aus einem HTSL-Material, der beispielsweise aus einer 5 mm dicken Platte aus dem HTSL-Material mittels Schlitzungen herausgearbeitet ist. Der elektrische Leiter ist selbsttragend, kann jedoch zur Erhöhung der mechanischen Stabilität auf einem Trägerkörper angeordnet sein. Das HTSL-Material ist auf pulvermetallurgischem Wege ausgebildet. Es besitzt eine verhältnismäßig geringe kritische Stromdichte $j_c$, so daß der Leiterbahnquerschnitt für Nennströme von beispielsweise 25 A entsprechend groß sein muß. Ein großer Querschnitt bedingt auch eine große Länge, um den für die Begrenzerwirkung erforderlichen Normalleitungswiderstand zu erzeugen. Der Aufwand an HTSL-Material ist dementsprechend groß. Viel Material bedeutet auch lange Abkühlzeiten nach einem Ansprechen (Schaltvorgang) des Begrenzers; d.h., ein Wieder-Einschalten des Stromes ist erst nach einer erheblichen Zeitverzögerung möglich.

Aus Advances in Superconductivity V (Proc. 5th Intern. Symp. on Supercond./ISS'92)", Springer-Verlag 1993, Seiten 1263 bis 1266 ist eine Studie über eine Strombegrenzungseinrichtung zu entnehmen. Daraus geht ein auf einem $SrTiO_3$-Substrat von 20 mm Durchmesser abgeschiedener und 0,4 µm dicker Film aus Hoch-$T_c$-Supraleitermaterial mit einer Stromdichte von $1{,}6 \cdot 10^6$ A/cm$^2$ hervor. Der Film ist zu einer mäanderförmigen, 40 mm langen und 1 mm breiten Leiterbahn strukturiert. Mit entsprechenden Strombegrenzungseinrichtungen sind jedoch die bekannten Anforderungen an einen Einsatz in den vorstehend erwähnten Wechselstromversorgungsnetze nicht zu erfüllen.

Aufgabe der vorliegenden Erfindung ist es, die Strombegrenzungseinrichtung mit den eingangs genannten Merkmalen dahingehend auszubilden, daß auf eine aufwendige Strukturierung des Supraleitermaterials verzichtet werden kann und dennoch ein schnelles Ansprechen der Einrichtung zu gewährleisten ist.

Diese Aufgabe wird erfindungsgemäß mit den in Anspruch 1 aufgeführten Maßnahmen gelöst.

Die mit dieser Ausgestaltung der Strombegrenzungseinrichtung verbundenen Vorteile sind insbesondere darin zu sehen, daß auf geeigneten Substraten mittels an sich bekannter Abscheideverfahren verhältnismäßig großflächige Schichten aus einem Hoch-$T_c$-Supraleitermaterial mit einer höheren kritischen Stromdichte auszubilden sind als mit keramischen Herstellungsverfahren wie Pressen und Sintern zu erreichen ist. Bei verhältnismäßig geringen stromführenden Querschnitten sind dennoch die für Strombegrenzungseinrichtungen zu fordernden Ströme über die mindestens eine Leiterbahn zu führen. Im Fehlerfall erzeugt dann die hohe pro Volumen erzeugte Joulesche Wärme $j^2 \cdot \rho$ eine schnelle Aufheizung über die Sprungtemperatur $T_c$, so daß entsprechend kurze Ansprechzeiten der Strombegrenzungseinrichtung zu erreichen sind. Insgesamt sind das abzuscheidende Materialvolumen und die zu beschichtende Substratoberfläche bei den erfindungsgemäß hohen Stromdichten verhältnismäßig gering. Entsprechend sind Bauvolumen und Herstellungskosten der Strombegrenzungseinrichtung niedrig. Ein weiterer Vorteil von dünnen Filmen gegenüber dicken, aus HTSL-Keramikkörpern herausgearbeiteten Leiterbahnen ist die verhältnismäßig große vom Kühlmittel benetzte Oberfläche im Verhältnis zum Volumen. Der nach dem Ansprechen über die Sprungtemperatur $T_c$ aufgeheizte Supraleiter kühlt so schnell ab und geht entsprechend schnell wieder in seinen supraleitenden Zustand zurück. Dies ist erwünscht, um einen zugeordneten Stromkreis möglichst ohne lange Unterbrechung wieder schließen zu können.

Vorteilhafte Ausgestaltungen der erfindungsgemäßen Strombegrenzungseinrichtung gehen aus den abhängigen Ansprüchen hervor.

Die Erfindung wird nachfolgend unter Bezugnahme auf die Zeichnung noch weiter erläutert. Dabei zeigen jeweils schematisch deren

Figur 1 im Längsschnitt eine erste Ausführungsform eines Strombegrenzerelementes einer Strombegrenzungseinrichtung,

Figur 2 im Längsschnitt einen Teil einer zweiten Ausführungsform eines Strombegrenzerelementes,

Figur 3 im Längsschnitt eine dritte Ausführungsform eines Strombegrenzerelementes,

Figur 4 in Schrägansicht eine Strombegrenzungseinrichtung mit einem Stapel von Strombegrenzerelementen

und

Figur 5 in Schrägansicht einen weiteren Stapel von Strombegrenzerelementen.

In den Figuren sind sich entsprechende Teile mit denselben Bezugszeichen versehen.

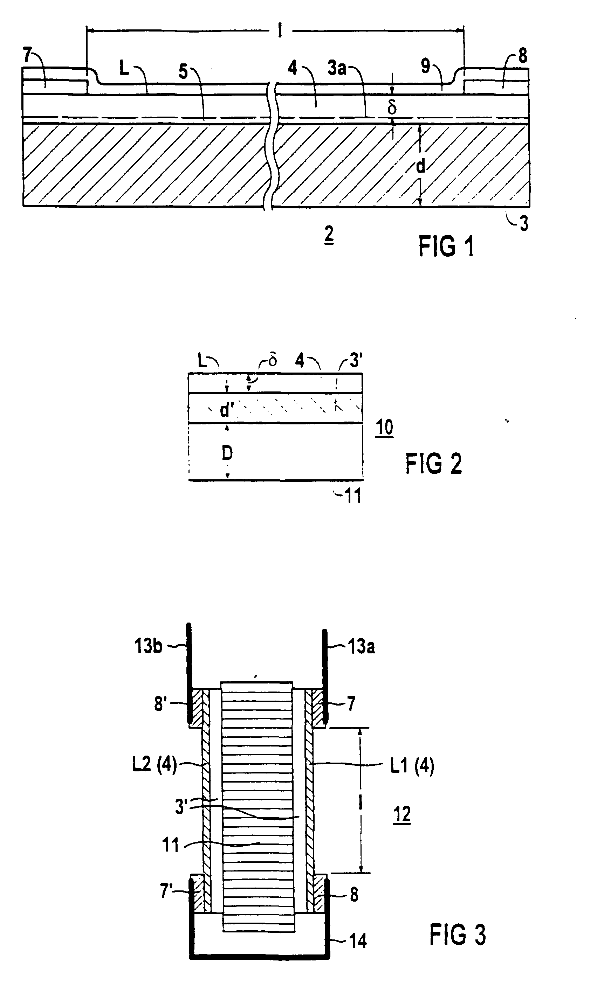

Eine erfindungsgemäße Strombegrenzungseinrichtung weist mindestens ein Strombegrenzerelement auf, das auf wenigstens einer seiner beiden gegenüberliegenden Flachseiten eine oder mehrere Leiterbahnen aus einem Hoch-$T_c$-Supraleitermaterial (HTSL-Material) enthält. In Figur 1 ist ein einzelnes Strombegrenzerelement einer solchen Strombegrenzungseinrichtung angedeutet und allgemein mit 2 bezeichnet. Es weist ein elektrisch isolierendes Substrat 3 vorbestimmter Dicke d auf, auf dessen mindestens einer Flachseite 3a eine Schicht 4 aus einem HTSL-Material mit einer vorbestimmten Dicke $\delta$ aufgebracht ist. Das Substrat kann in entsprechender Weise auch beidseitig beschichtet sein. Die Dicke $\delta$ der Schicht 4 soll dabei höchstens 200 µm, vorzugsweise höchstens 100 µm betragen. Als HTSL-Materialien kommen alle bekannten metalloxidischen Supraleitermaterialien in Frage, deren Sprungtemperatur $T_c$ so hoch liegt, daß sie mit flüssigem Stickstoff ($LN_2$) auf ihrer supraleitenden Betriebstemperatur von beispielsweise etwa 77 K zu halten sind. Vorzugsweise besteht die Schicht 4 aus einem polykristallinen, texturierten HTSL-Material gemäß dem Typ $YBa_2Cu_3O_{7-x}$ mit einer Korngröße unter 1 µm und einer Schichtdicke $\delta$ zwischen 1 µm und 30 µm. Das Supraleitermaterial wird vorzugsweise durch Laserablation, Sputtern, PlasmaFlash-Verfahren oder durch Verdampfen der Metalle Y, Ba und Cu in einer Sauerstoffatmosphäre aufgebracht. Alternativ kann auch schmelztexturiertes HTSL-Material gemäß dem Typ $Bi_2Sr_2CaCu_2O_y$ oder $Bi_2Cr_2Ca_2Cu_3O_z$ mit einer Schichtdicke $\delta$ von vorzugsweise 5 bis 100 µm verwendet werden, das beispielsweise durch Wärmebehandlung einer auf das Substrat 3 aufgebrachten Schicht aus einem Vorprodukt des Materials, einer sogenannten Precursorschicht, erzeugt wird. Ein entsprechendes Verfahren mit Siebdruck einer mit organischem Binder angesetzten Precursorpaste ist beispielsweise in der DE 43 08 681 A beschrieben. Als Texturierhilfe kann auf dem Substrat 3 gegebenenfalls eine dünne Zwischenschicht 5 aus Ag von höchstens 1/30 der HTSL-Schichtdicke $\delta$ aufgebracht sein. Die kritische Stromdichte $j_c$ des HTSL-Materials in der Schicht 4 soll bei einer Temperatur T=77 K im Eigenfeld mindestens $10^3$ A/cm$^2$, vorzugsweise mindestens $10^4$ A/cm$^2$, betragen.

Für das Substrat 3 kommen vorzugsweise elektrisch nicht-leitende Materialien in Frage, die ein texturiertes Wachstum des HTSL-Materials ermöglichen. Dies sind beispielsweise feinkristallines, dichtes Yttrium-stabilisiertes $ZrO_2$, $Al_2O_3$, MgO oder ein anderes Metalloxid. Es ist auch ein Glas verwendbar, das mit einer dünnen polykristallinen Pufferschicht, z. B. aus $ZrO_2$, belegt ist.

Zur Erzeugung eines dem geforderten Nennstrom $I_n$ angepaßten Querschnittes kann die HTSL-Schicht 4 während der Schichtabscheidung z.B. mittels einer Maske, oder erst anschließend chemisch oder mechanisch strukturiert werden, so daß sich ein induktionsarmer Verlauf einer Leiterbahn L mit vorgegebener Breite und Länge 1 ergibt. Vorzugsweise hat die Oberfläche der Leiterbahn L gemäß dem dargestellten Ausführungsbeispiel eine Rechteckform. Gegebenenfalls kann sie aber auch zu einem "U" gestaltet sein. Der durch das Produkt aus Dicke $\delta$ und Breite bestimmte Querschnitt der Leiterbahn L ist so zu bemessen, daß der Spitzenwert $\sqrt{2}*I_n$ bei dem Nennstrom $I_n$ unterhalb des kritischen Stromes $I_c$ der Schicht 4 bleibt. Die effektive Gesamtlänge 1 der Leiterbahn bzw. aller Leiterbahnen einer Strombegrenzungseinrichtung in Stromführungsrichtung gesehen muß außerdem so groß gewählt werden, daß der elektrische Widerstand $R_n$ oberhalb der Sprungtemperatur $T_c$ des HTSL-Materials vorzugsweise einen Wert $R_n \geq U_n / I_n$ aufweist. $U_n$ ist dabei die Nennspannung.

An den Enden der supraleitenden Leiterbahn sind großflächige Kontaktflächen 7 und 8 insbesondere aus Ag durch Beschichtungsverfahren wie Sputtern oder Aufdampfen oder durch Einbrennen einer Ag-Paste aufgebracht. Diese Kontaktflächen werden dann mittels Löt-, Preß- oder Federkontakten mit elektrischen Zuleitungen verbunden.

Zum Schutz des HTSL-Materials gegen Umwelteinflüsse wie Feuchtigkeit kann zumindest das Supraleitermaterial noch mit einer Isolatorschicht 9 von 10 bis 100 $\mu$m Dicke abgedeckt werden.

Ein erfindungsgemäßer Aufbau eines Strombegrenzerelementes einer Strombegrenzungseinrichtung ist in Figur 2 als Teilstück angedeutet. Bei diesem Strombegrenzerelement 10 ist das HTSL-Material

Ein erfindungsgemäßer Aufbau eines Strombegrenzerelementes einer Strombegrenzungseinrichtung ist in Figur 2 als Teilstück angedeutet. Bei diesem Strombegrenzerelement 10 ist das HTSL-material der Schicht 4 auf einem verhältnismäßig dünnen Substrat 3' aus einem der genannten Substratmaterialien aufgebracht. Die Dicke d' des Substrats 3' liegt dabei vorzugsweise zwischen 50 $\mu$m und 5 mm, beispielsweise zwischen 0,1 mm und 2 mm. Das Substrat 3', beispielsweise aus $ZrO_2$, ist seinerseits auf einem vergleichsweise dickeren Trägerkörper 11 fest angeordnet, z.B. auf diesem angeklebt. Die Dicke D des Trägerkörpers ist vorzugsweise mindestens zweimal so groß wie die des Substrats 3'. Der Trägerkörper wird vorteilhaft aus einem metallischen oder insbesondere isolierenden Material erstellt, das beim Abkühlen auf die Betriebstemperatur des Strombegrenzerelementes 10 von beispielsweise 77 K in wesentlich geringerem Masse schrumpft als der Verbund aus HTSL-Schicht 4 und Substrat 3' ohne Trägerkörper. Der unbeschichtete Trägerkörper soll nach der Abkühlung insbesondere um mindestens das 1,5-fache, vorzugsweise um mindestens das 5- bis 10-fache, weniger geschrumpft sein als ein Verbund allein aus dem Substrat 3' und der zugeordneten Leiterbahn L bei einer entsprechenden Abkühlung schrumpfen würde. Im kalten Betriebszustand steht dann die HTSL-Schicht 4 sowie das Substrat 3' unter mechanischem Zug. Die entsprechende Zugspannung wird beim Ansprechen des Strombegrenzerelementes 10, einem sogenannten Schaltvorgang, welcher mit einer sehr schnellen Aufheizung der HTSL-Schicht 4 um 100 bis 200 K verbunden ist, durch die dadurch bewirkte thermische Ausdehnung zumindest teilweise abgebaut. Es läßt sich so vorteilhaft erreichen, daß das HTSL-Material weniger oder gar nicht mehr unter mechanischen Druck parallel zur Oberfläche gerät. Die Gefahr einer lokalen Aufwölbung oder eines Abplatzens und damit Durchbrennens der HTSL-Leiterbahn L kann so vermieden werden.

Ein verhältnismäßig dicker, plattenförmiger Trägerkörper 11 kann gemäß Figur 3 ein- oder beidseitig mit Leiterbahnen L1 und L2 bildenden HTSL-Schichten 4 belegt sein. Er sorgt ferner für die mechanische Stabilität der HTSL-Schichten, wenn in einem Kurzschlußfall das das Strombegrenzerelement 12 kühlende Kühlmittel infolge der eingebrachten Jouleschen Wärmeentwicklung von etwa der Nennleistung $U_n*I_n$ heftig verdampft.

Ein weiterer Vorteil dieser Ausführungsform des Strombegrenzerelementes 12 liegt darin, daß nur das verhältnismäßig kleine Volumen des dünnen Substrats 3' z.B. aus $ZrO_2$ den hohen Anforderungen an Dichte, Porenfreiheit, Temperaturbeständigkeit und Oberflächenqualität genügen muß, welche die HTSL-Präparation verlangt. Da der Trägerkörper 11 nicht den entsprechenden Abscheideprozeß durchläuft, kann er vorteilhaft aus billigerem Material bestehen.

Geeignete Materialien lassen sich anhand der relativen thermischen Kontraktion $\Delta I/I$ beim Abkühlen von Raumtemperatur (300 K) auf die Betriebstemperatur (77 K) auswählen. Einige Beispiele sind der nachfolgenden Tabelle zu entnehmen. Dabei sind 1 die Länge der HTSL-Schicht 4 und $\Delta I$ der Schrumpfungswert der Schicht.

Tabelle

| Supraleiterschicht und Substrat | $\Delta I/I$ | Trägerkörper $\Delta I/I$ |
|---|---|---|
| $YBa_2Cu_3O_7$ in ab-Richtung | $-2 \cdot 10^{-3}$ | Quarzglas = 0 |
| $Bi_2Sr_2CaCu_2O_8$ in ab-Richtung | $-1.5 \cdot 10^{-3}$ | Glaskeramik ("CERAN") $\approx$ 0 |
| Y-stabilsiertes $ZrO_2$ | $-2 \cdot 10^{-3}$ | Jenaer Glas $-0.3...0.5 \cdot 10^{-3}$ |
| $Al_2O_3$ | $-1.4 \cdot 10^{-3}$ | Bor-Silikat-Glas $-0.6 \cdot 10^{-3}$ |

Neben Trägerkörpern 11 aus Glas oder Glaskeramik oder einem glasähnlichen Material mit geringer thermischer Ausdehnung sind auch Platten aus gefüllter Kunststoffmasse geeignet, wobei durch Wahl des Füll- oder Fasermaterials eine thermische Schrumpfung $\Delta l/l$ zwischen 300 K und 77 K von $10^{-3}$ oder weniger eingestellt werden kann.

Gemäß Figur 3 sind an ihren Enden die Leiterbahn L1 des Strombegrenzungselementes 12 mit Kontaktflächen 7 und 8 und die Leiterbahn L2 mit Kontaktflächen 7' und 8' versehen. An den Kontaktflächen 7 und 8' sind Stromzuleitungen 13a bzw. 13b angeschlossen. Die Leiterbahnen L1 und L2 sind an ihren Kontaktflächen 8 bzw. 7' über eine Verbindungsbrücke 14 elektrisch hintereinander geschaltet.

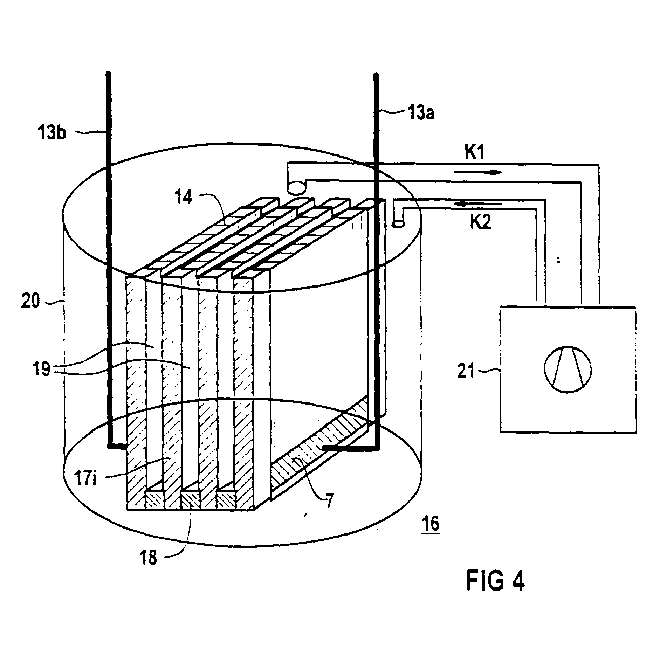

Die in den Figuren 1 bis 3 dargestellten Ausführungsformen stellen plattenförmige Strombegrenzerelemente einer Strombegrenzungseinrichtung dar. Selbstverständlich können gemäß Figur 4 im Bedarfsfalle, insbesondere für höhere Spannungen, mehrere solcher plattenförmigen Begrenzerelemente zu einem Stapel einer Strombegrenzungseinrichtung 16 zusammengefaßt und elektrisch in Serie geschaltet werden. Für höhere Nennströme können ebenso auch mehrere Strombegrenzerelemente parallelgeschaltet werden. In der Figur sind elektrische Verbindungsstücke zur Zusammenschaltung der einzelnen Begrenzerelemente 17i mit 18 bezeichnet. Die Begrenzerelemente entsprechen z. B. im wesentlichen dem Element 12 nach Figur 3. Die Begrenzerelemente 17i sind untereinander beabstandet. Es bleiben so zwischen den Elementen senkrechte Kühlkanäle 19. Beim vollständigen Eintauchen des Stapels in das in einem Kryostatengefäß 20 befindliche Kühlmittel wie flüssiger Stickstoff ist so eine schnelle Wärmeabfuhr zu gewährleisten. Die elektrischen Stromzuleitungen 13a und 13b des Plattenstapels können als abgasgekühlte Stromzuführungen gestaltet sein. Das verdampfte Kühlmittel K1 wird in einer Kältemaschine 21 rückverflüssigt und als flüssiges Kühlmittel K2 in Form von $LN_2$ in das Kryostatengefäß 20 eingespeist.

Für Strombegrenzungseinrichtungen, die für Drehstrom ausgelegt sind, können drei entsprechende Plattenstapel in einem gemeinsamen Kryostatengefäß untergebracht werden.

Im folgenden sind einige konkrete Werte eines Ausführungsbeispieles einer Strombegrenzungseinrichtung für 10 MVA Nennleistung angegeben, wobei ein Aufbau gemäß Figur 4 zugrundegelegt ist. In einem 30 MVA-Abzweig einer Mittelspannungsschaltanlage wäre für jede Phase ein entsprechender Plattenstapel vorzusehen:

| | |
|---|---|
| Spannung (Phase gegen Null) | 15 kV |
| Nennstrom | 600 A |
| Supraleiter | Film aus polykristallinem $YBa_2Cu_3O_{7-x}$ |
| - Sprungtemperatur | 89 Kelvin |
| - Kritische Stromdichte | 40 kA/cm$^2$ |
| - Spezif. elektr. Widerstand | 100 µOhm·cm bei T=100 Kelvin |
| Schaltelement | Beidseitig beschichtete Platte |
| - Leiterbreite | 0,25 m |
| - Schichtdicke | 10 µm |
| - kritischer Strom | 1000 A |
| - Länge insgesamt | 50 m |
| - Widerstand über $T_c$ | 20 Ohm |
| Substrat | Y-stabilisierte $ZrO_2$-Keramik |
| | 0,25 x 1 m$^2$ x 5 mm |
| Plattenstapel | 25 Platten elektrisch in Serie |
| Spannungsbegrenzung | Parallelshunt 20 Ohm außerhalb Begrenzer |
| Abschaltverzögerung Lasttrenner | 50 ms |
| Abschaltstrom Lasttrenner | 1500 A |
| In Supraleiter umgesetzte Energie | $\approx$ 500 kJ |
| Verdampfte Stickstoffmenge | = 3 Liter |
| Wiederabkühlzeit | $\approx$ 10 s |

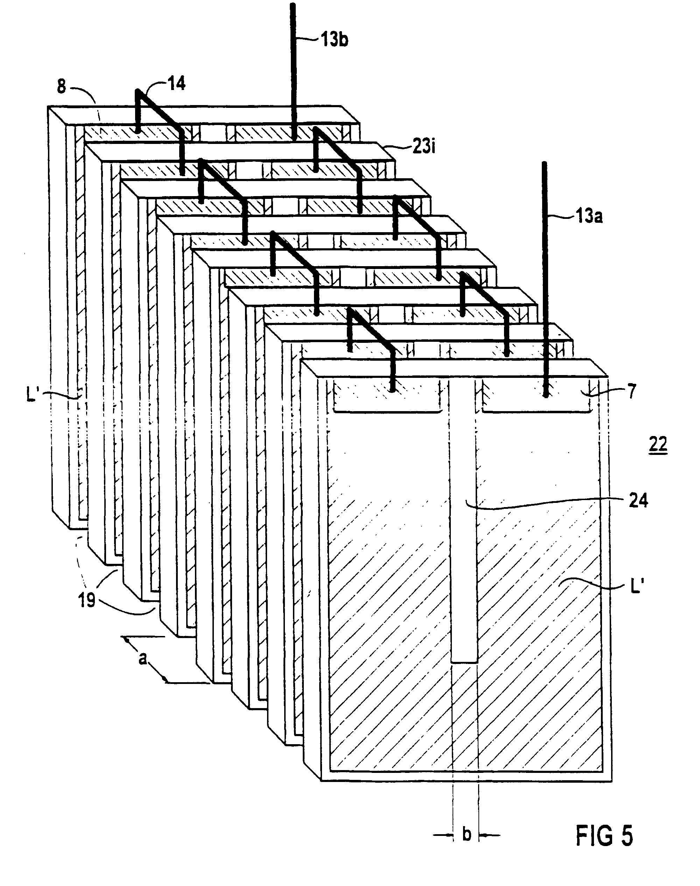

Figur 5 zeigt einen weiteren Stapel einer Strombegrenzungseinrichtung 22 aus einseitig mit HTSL-Material beschichteten Begrenzerelementen 23i. Im Gegensatz zu der Ausführungsform nach den Figuren 3 und 4 ist hier jedoch jede Leiterbahn L' aus dem HTSL-Material U-förmig ausgeführt. Zwischen den beiden Ästen (Schenkeln) der U-Form ist ein von HTSL-Material freier Zwischenraum 24 der Breite b vorhanden. Innerhalb des Stapels sind die Begrenzerelemente 23i gegenseitig beabstandet, so daß zwischen ihnen Kühlkanäle 19 gewährleistet sind. Der mittlere Abstand zwischen den Leiterbahnen L' aus benachbarten Begrenzerelementen 23i ist mit a bezeichnet. Vorteilhaft wird für die Breite b des Zwischenraumes 24 der Leiterbahnen L' wenigstens annähernd ein solcher Wert gewählt, daß er mindestens dem halben mittleren Abstand a entspricht. Hiermit läßt sich vorteilhaft erreichen, daß sich die gegenläufigen Feldlinien der Eigenfelder des Stromes um die Leiterbahnen über den Zwischenraum 24 ohne Feld- und Stromüberhöhung an den Rändern der HTSL-Leiterbahnen schließen können.

**Patentansprüche**

1. Resistive Strombegrenzungseinrichtung (2, 16, 22) mit

   - einem Trägerkörper (11) vorbestimmter Dicke (D),
   - einem auf der wenigstens einen Flachseite (3a) des Trägerkörpers (11) fest angeordneten, elektrisch isolierenden Substrat (3, 3'), dessen Dicke (d) zwischen 50 μm und 5 mm liegt und vergleichsweise geringer als die Trägerkörperdicke (D) ist,

   sowie

   - mindestens einer Leiterbahn (L, L1, L2, L'), welche

     a) für einen vorbestimmten Nennstrom ausgelegt ist,
     b) aus einer auf dem Substrat (3, 3') befindlichen, höchstens 200 μm dicken Schicht (4) aus einem Hoch-$T_c$-Supraleitermaterial ausgebildet ist, deren kritische Stromdichte bei 77 K im Eigenfeld mindestens $10^3$ A/cm$^2$ beträgt,
     und
     c) an ihren Enden mit elektrischen Kontaktflächen (7, 8; 7', 8') zur Stromzuführung versehen ist.

2. Einrichtung nach Anspruch 1, **dadurch gekennzeichnet, daß** der Trägerkörper (11) aus einem metallischen oder isolierenden Werkstoff besteht.

3. Einrichtung nach Anspruch 1 oder 2, **dadurch gekennzeichnet, daß** der Trägerkörper (11) aus einem solchen Werkstoff besteht, daß er nach einem Abkühlen auf die Betriebstemperatur des Hoch-$T_c$-Supraleitermaterials um mindestens das 1,5-fache weniger geschrumpft ist als der Verbund aus Substrat (3') und zugeordneter Leiterbahn (L, L1, L2, L') ohne Trägerkörper bei einem entsprechenden Abkühlen schrumpfen würde.

4. Einrichtung nach Anspruch 3, **dadurch gekennzeichnet, daß** die Schrumpfung des Trägerkörpers (11) mindestens um das 5-fache, vorzugsweise mindestens um das 10-fache, geringer ist als die Schrumpfung des Verbundes aus Substrat (3') und Leiterbahn (L, L1, L2, L').

5. Einrichtung nach einem der Ansprüche 2 bis 4, **dadurch gekennzeichnet, daß** als Material des Trägerkörpers (11) ein Glas oder ein glasähnliches Material vorgesehen ist.

6. Einrichtung nach einem der Ansprüche 1 bis 5, **dadurch gekennzeichnet, daß** als Hoch-$T_c$-Supraleitermaterial der Schicht (4) ein polykristallines Material gemäß dem Typ YBa$_2$Cu$_3$O$_{7-x}$ mit einer Korngröße unter 1 μm vorgesehen ist.

7. Einrichtung nach einem der Ansprüche 1 bis 5, **dadurch gekennzeichnet, daß** als Hoch-$T_c$-Supraleitermaterial (4) ein schmelztexturiertes Material gemäß dem Typ Bi$_2$Sr$_2$CaCu$_2$O$_y$ und/oder Bi$_2$Sr$_2$Ca$_2$Cu$_3$O$_z$ vorgesehen ist.

8. Einrichtung nach einem der vorangehenden Ansprüche, **dadurch gekennzeichnet, daß** als Hoch-$T_c$-Supraleitermaterial der Schicht (4) ein Material mit einer kritischen Stromdichte von mindestens $10^4$ A/cm$^2$ vorgesehen ist.

9. Einrichtung nach einem der vorangehenden Ansprüche, **dadurch gekennzeichnet, daß** der Querschnitt der einen Nennstrom In führenden mindestens einen Leiterbahn (L, L1, L2, L') so bemessen ist, daß der Spitzenwert $\sqrt{2}*I_n$ bei dem Nennstrom In unterhalb des kritischen Stromes $I_c$ der mindestens einen Leiterbahn bleibt.

10. Einrichtung nach einem der vorangehenden Ansprüche, **dadurch gekennzeichnet**, **dadurch gekennzeichnet, daß** die einen Nennstrom In führende mindestens eine Leiterbahn (L, L1, L2, L') eine solche effektive Gesamtlänge (1) in der Einrichtung aufweist, daß der elektrische Widerstand $R_n$ über die Gesamtlänge (1) bei einer Temperatur oberhalb der Sprungtemperatur $T_c$ des Hoch-$T_c$-Supraleitermaterials zumindest den Wert $U_n/I_n$ aufweist, wobei $U_n$ die Nennspannung an der Einrichtung ist.

**11.** Einrichtung nach einem der vorangehenden Ansprüche, **dadurch gekennzeichnet, daß** die mindestens eine Leiterbahn (L') U-förmig gestaltet ist.

**12.** Einrichtung nach einem der vorangehenden Ansprüche, **gekennzeichnet durch** mehrere elektrisch zusammengeschaltete Strombegrenzerelemente (17i, 23i), die jeweils mindestens eine Leiterbahn (L, L1, L2, L') aus dem Hoch-$T_c$-Supraleitermaterial aufweisen.

**13.** Einrichtung nach Anspruch 12, **dadurch gekennzeichnet, daß** die Strombegrenzerelemente (17i, 23i) zu einem Stapel unter gegenseitiger Beabstandung angeordnet sind.

**Claims**

**1.** A resistive current-limiting device (2, 16, 22) having

- a carrier body (11) of a predetermined thickness (D),
- an electrically insulating substrate (3, 3') which is permanently arranged on the at least one flat side (3a) of the carrier body (11) and whose thickness (d) is between 50 μm and 5 mm and is comparatively smaller than the carrier body thickness (D),

and also

- at least one conductor path (L, L1, L2, L') which

    a) is designed for a predetermined nominal current,
    b) is formed from a layer (4) of a high-$T_c$-superconductive material which has a maximum thickness of 200 μm and is arranged on the substrate (3, 3'), and whose critical current density at 77 K in the self-field amounts to at least $10^3$ A/cm$^2$,
    and
    c) is provided at its ends with electric contact surfaces (7, 8; 7', 8') for the current supply.

**2.** A device according to claim 1, **characterised in that** the carrier body (11) consists of a metallic or insulating material.

**3.** A device according to claim 1 or 2, **characterised in that** the carrier body (11) consists of a material such that, following cooling to the operating temperature of the high-$T_c$-superconductive material, it has shrunk by at least 1.5 times less than the combination of substrate (3') and associated conductor path (L, L1, L2, L') without the carrier body would shrink in the case of corresponding cooling.

**4.** A device according to claim 3, **characterised in that** the shrinkage of the carrier body (11) is at least five times, preferably at least ten times, less than the shrinkage of the combination of substrate (3') and conductor path (L, L1, L2, L').

**5.** A device according to one of claims 2 to 4, **characterised in that** a glass or glass-like material is provided as the material of the carrier body (11).

**6.** A device according to one of claims 1 to 5, **characterised in that** a polycrystalline material in accordance with the YBa$_2$Cu$_3$O$_{7-x}$ type with a grain size of less than 1 μm is provided as the high-$T_c$-superconductive material of the layer (4).

**7.** A device according to one of claims 1 to 5, **characterised in that** a melt-textured material in accordance with the Bi$_2$Sr$_2$CaCu$_2$O$_y$ and/or Bi$_2$Sr$_2$Ca$_2$Cu$_3$O$_z$ type is provided as the high-$T_c$-superconductive material (4).

**8.** A device according to one of the preceding claims, **characterised in that** a material with a critical current density of at least $10^4$ A/cm$^2$ is provided as the high-$T_c$-superconductive material of the layer (4).

**9.** A device according to one of the preceding claims, **characterised in that** the cross-section of the at least one conductor path (L, L1, L2, L') conducting a nominal current $I_n$ is dimensioned such that the peak value $\sqrt{2}*In$ at

the nominal current In remains below the critical current $I_c$ of the at least one conductor path.

10. A device according to one of the preceding claims, **characterised in that** the at least one conductor path (L, L1, L2, L') conducting a nominal current $I_n$ has an effective overall length (1) in the device such that the electric resistance $R_n$ along the overall length (1) at a temperature above the transition temperature $T_c$ of the high-$T_c$-superconductive material has at least the value $U_n/I_n$, where $U_n$ is the nominal voltage connected to the device.

11. A device according to one of the preceding claims, **characterised in that** the at least one conductor path (L') is U-shaped.

12. A device according to one of the preceding claims, **characterised by** a plurality of electrically interconnected current-limiting elements (17i, 23i) which each comprise at least one conductor path (L, L1, L2, L') composed of the high-$T_c$-superconductive material.

13. A device according to claim 12, **characterised in that** the current-limiting elements (17i, 23i) are arranged to form a stack in which they are spaced from one another.


**Revendications**

1. Limiteur (2, 16, 22) de courant résistif comprenant

   - un support (11) d'épaisseur (D) déterminée à l'avance,
   - un substrat (3, 3') disposé de manière fixe sur au moins une face (3a) plane du support (11), isolant électriquement, d'épaisseur (d) comprise entre 50 µm et 5 mm et relativement plus petite que l'épaisseur (D) du support,

   ainsi que

   - au moins une piste (L, L1, L2, L') conductrice qui

      a) est conçue pour un courant nominal déterminé à l'avance,
      b) est constituée d'une couche (4) en un matériau supraconducteur à $T_c$ haute se trouvant sur le substrat (3, 3') et d'une épaisseur de 200 µm au plus, dont la densité de courant critique à 77 K dans le champ propre est d'au moins $10^3$ A/cm$^2$,
      et
      c) est munie à ses extrémités de surfaces (7, 8 ; 7', 8') de contact pour l'arrivée du courant.

2. Limiteur suivant la revendication 1, **caractérisé en ce que** le support (11) est en un matériau métallique ou en un matériau isolant.

3. Limiteur suivant la revendication 1 ou 2, **caractérisé en ce que** le support (11) est en un matériau tel qu'il se rétracte après un refroidissement à la température de fonctionnement du matériau supraconducteur à $T_c$ haute d'au moins 1,5 fois moins que ne se rétracterait à un refroidissement correspondant le composite constitué du substrat (3') et de la piste (L, L1, L2, L') conductrice associée sans support.

4. Limiteur suivant la revendication 3, **caractérisé en ce que** le retrait du support (11) est plus petit d'au moins 5 fois, de préférence d'au moins 10 fois, que le retrait du composite composé du substrat (3') et de la piste (L, L1, L2, L') conductrice.

5. Limiteur suivant l'une des revendications 2 à 4, **caractérisé en ce qu'**il est prévu comme matière du support (1) un verre ou une matière analogue à du verre.

6. Limiteur suivant l'une des revendications 1 à 5, **caractérisé en ce qu'**il est prévu comme matière supraconductrice à $T_c$ haute de la couche (4) une matière polycristalline suivant le type $YBa_2Cu_3O_{7-x}$ d'une granulométrie inférieure à 1 µm.

7. Limiteur suivant l'une des revendications 1 à 5, **caractérisé en ce qu'**il est prévu comme matière (4) supraconductrice à $T_c$ haute une matière texturée par fusion suivant le type $Bi_2Sr_2CaCu_2O_y$ et/ou $Bi_2Sr_2Ca_2Cu_3O_z$.

8. Limiteur suivant l'une des revendications précédentes, **caractérisé en ce qu'**il est prévu comme matière supraconductrice à $T_c$ haute de la couche (4) une matière ayant une densité de courant critique d'au moins $10^4$ A/cm$^2$.

9. Limiteur suivant l'une des revendications précédentes, **caractérisé en ce que** la section transversale de la au moins une piste (L, L1, L2, L') conductrice dans laquelle passe un courant $I_n$ nominal est telle que la valeur de crête $\sqrt{2}*I_n$ pour le courant $I_n$ nominal reste inférieure au courant $I_c$ critique de la au moins une piste conductrice.

10. Limiteur suivant l'une des revendications précédentes, caractérisé en ce la au moins une piste (L, L1, L2, L') conductrice dans laquelle passe un courant $I_n$ nominal a une longueur (1) totale efficace telle dans le limiteur que la résistance $R_n$ électrique sur toute la longueur (1) a, à une température supérieure à la température $T_c$ de changement brusque de conductivité de la matière supraconductrice à $T_c$ haute, au moins la valeur $U_n/I_n$, $U_n$ étant la tension nominale appliquée au limiteur.

11. Limiteur suivant l'une des revendications précédentes, **caractérisé en ce que** la au moins une piste (L') conductrice est en forme de U.

12. Limiteur suivant l'une des revendications précédentes, **caractérisé par** plusieurs éléments (17i, 23i) limiteurs de courant montés ensemble électriquement qui ont respectivement au moins une piste (L, L1, L2, L') conductrice en la matière supraconductrice à $T_c$ haute.

13. Limiteur suivant la revendication 12, **caractérisé en ce que** les éléments (17i, 23i) de limitation du courant sont disposés en une pile à distance mutuelle.

**FIG 1**

**FIG 2**

**FIG 3**

FIG 4

FIG 5